# EUROPEAN PATENT APPLICATION

(11) **EP 4 727 282 A1**
(43) Date of publication of application: **15.04.2026**
(21) Application number: 25204572.9
(22) Date of filing: 25.09.2025
(51) Int. Cl.: H10D 1/68, H10B 12/00

(54) **CAPACITOR, SEMICONDUCTOR DEVICE INCLUDING THE CAPACITOR, AND METHOD OF MANUFACTURING THE SEMICONDUCTOR DEVICE**

(30) Priority: 11.10.2024 KR 20240138623; 09.07.2025 KR 20250092582
(71) Applicant: SAMSUNG ELECTRONICS CO., LTD., Yeongtong-gu Suwon-si, Gyeonggi-do 16677 (KR)
(72) Inventor: KIM, Haeryong, 16678 Suwon-si (KR); NA, Byunghoon, 16678 Suwon-si (KR); CHO, Eunae, 16677 Suwon-si (KR)
(74) Representative: Elkington and Fife LLP

(57) **Abstract**

Provided are a capacitor, a semiconductor device including the capacitor, and a method of manufacturing the semiconductor device. The capacitor includes a first electrode, a second electrode opposing the first electrode, and a dielectric layer provided between the first electrode and the second electrode and including a rutile crystal phase. The first electrode includes a metal nitride, and the metal nitride includes a Group 5B element, or a Group 5B element and a Group 4B element.

## Description

### FIELD OF THE INVENTION

The disclosure relates to a capacitor, a semiconductor device including the capacitor, and a method of manufacturing the semiconductor device.

### BACKGROUND OF THE INVENTION

Memory cells, which may be a basic unit of dynamic random-access memory (DRAM), may each include a transistor that controls charge transfer and a capacitor that stores charge. In order to meet demands for higher integration, the size of DRAM memory cells has continuously been reduced, and as a result of this miniaturization, the charge storage capacity of DRAM capacitors may be reduced. Therefore, methods and materials for enhancing the permittivity of capacitor dielectric layers are being explored to improve the charge storage capacity of capacitors while compensating for this reduction in size.

### SUMMARY OF THE INVENTION

Provided are a capacitor, a semiconductor device including the capacitor, and a method of manufacturing the semiconductor device.

Additional aspects will be set forth in part in the description which follows and, in part, will be apparent from the description, or may be learned by practice of the presented embodiments of the disclosure.

According to an aspect of the disclosure, a capacitor includes: a first electrode, the first electrode comprising a metal nitride, the metal nitride comprising a nitride of a Group 5B element or a nitride of the Group 5B element and a Group 4B element; a second electrode opposing the first electrode; and a dielectric layer between the first electrode and the second electrode, the dielectric layer and comprising a rutile crystal phase.

Embodiments may facilitate improvement of dielectric capacitor characteristics using electrode. Also, embodiments may provide for improvement of capacitor characteristics using electrodes.

In embodiments of the present invention, a phase control layer formed at the interface between the electrode and TiO₂ may be applied to realize the rutile phase of TiO₂ . A structure capable of maintaining the characteristics of the high-k TiO₂ dielectric film may be formed by using such an electrode material. Embodiments aim to improve the dielectric characteristics representing the charge controllability of the capacitor by implementing a structure that enhances such characteristics, and to improve the capacitor characteristics by using materials excluding noble metals.

In embodiments, the structure of the MIM (Metal-Insulator-Metal) capacitor may include a nitride electrode and a phase control layer and may be composed of a dielectric film capable of inducing the rutile phase. By inducing TiO₂ rutile crystallization through the phase control layer (PCL) on the electrode and improving interfacial stability, the high-temperature/high-pressure stable high-k phase (rutile) may be implemented without using noble metals.

In some embodiments, a MIM (Metal-Insulator-Metal) capacitor includes a nitride electrode and a phase control layer, and may be composed of a dielectric film capable of inducing a rutile structure.

The dielectric layer may be in direct contact with the first electrode.

The dielectric layer may include TiO₂.

The dielectric layer may include the rutile crystal phase as a dominant phase.

The dielectric layer may have a thickness of 100 Å or less.

The Group 5B element may include at least one of V, Nb, Ta, or Db.

The Group 4B element may include at least one of Ti, Zr, Hf, or Rf.

The metal nitride may be represented by MN or MₓM'₁₋ₓN, where 0<x<1, M refers to the Group 5B element, M' refers to the Group 4B element, and N refers to nitrogen .

According to another aspect of the disclosure, a semiconductor device includes a capacitor including a first electrode, the first electrode comprises a metal nitride, and the metal nitride comprising a nitride of a Group 5B element or a nitride of the Group 5B element and a Group 4B element; a second electrode opposing the first electrode; and a dielectric layer between the first electrode and the second electrode, the dielectric layer comprising a rutile crystal phase .

The dielectric layer may be in direct contact with the first electrode.

The dielectric layer may include TiO₂.

The metal nitride may be represented by MN or MₓM'₁₋ₓN, where 0<x<1, M refers to a Group 5B element, M' refers to a Group 4B element, and N refers to nitrogen.

According to another aspect of the disclosure, there is provided a method of manufacturing a semiconductor device including a capacitor, the method including manufacturing the capacitor by: forming a first electrode comprising a metal nitride, the metal nitride comprising a Group 5B element; forming a dielectric layer on the first electrode such that the dielectric layer comprises a rutile crystal phase; and forming a second electrode on the dielectric layer.

The Group 5B element may include at least one of V, Nb, Ta, or Db.

The first electrode further may include a Group 4B element.

The Group 4B element may include at least one of Ti, Zr, Hf, or Rf.

The dielectric layer may include TiO₂.

The forming of the dielectric layer may include directly depositing TiO₂ on the first electrode through an atomic layer deposition (ALD) process.

The dielectric layer may include the rutile crystal phase as a dominant phase.

The forming the dielectric layer may include forming the dielectric layer such that the dielectric layer has a thickness of 100 Å or less .

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view schematically illustrating a capacitor according to at least one example embodiment;
FIGS. 2A to 2C are views illustrating a method of manufacturing the capacitor of the at least one example embodiment shown in FIG. 1;
FIG. 3 is a transmission electron microscope (TEM) image illustrating a rutile TiO₂ layer deposited on a VN electrode, according to at least one example embodiment;
FIG. 4 is a view illustrating simulation results showing variations in interfacial energy according to heat treatment performed on an oxynitride of a Group 5B element (M) and oxides of a Group 5B element (M);
FIG. 5 is a graph illustrating crystal phases observed when TiO₂ dielectric layers were respectively grown on layers of oxides of a Group 5B element (M) through an atomic layer deposition (ALD) process;
FIG. 6 is a graph illustrating results of measuring the leakage current density (J) and the equivalent oxide thickness (Toxeq.) of a capacitor of a comparative example and a capacitor of at least one example embodiment;
FIG. 7 is a circuit diagram schematically illustrating a circuit configuration and operation of a semiconductor device employing a capacitor, according to at least one example embodiment;
FIG. 8 is a view schematically illustrating a semiconductor device according to at least one example embodiment;
FIG. 9 is a view schematically illustrating a semiconductor device according to at least one example embodiment;
FIG. 10 is a plan view illustrating a semiconductor device according to at least one example embodiment;
FIG. 11 is a cross-sectional view taken along line A-A' of FIG. 10;
FIG. 12 is a cross-sectional view illustrating a semiconductor device according to at least one example embodiment; and
FIGS. 13 and 14 are conceptual views schematically illustrating device architectures applicable to electronic devices according to embodiments.

### DETAILED DESCRIPTION

Reference will now be made in detail to embodiments, examples of which are illustrated in the accompanying drawings. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described with reference to the accompanying drawings. In the drawings, like reference numerals refer to like elements, and the sizes of elements may be exaggerated for clarity of illustration. The embodiments described herein are for illustrative purposes only, and various modifications may be made therein. Additionally, when the terms "about" or "substantially" are used in this specification in connection with a numerical value and/or geometric term, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry.

In the following description, when an element is referred to as being "above" or "on" another element, it may be directly on an upper, lower, left, or right side of the other element while making contact with the other element or may be above an upper, lower, left, or right side of the other element without making contact with the other element. The terms of a singular form may include plural forms unless otherwise mentioned. It will be further understood that the terms "comprises" and/or "comprising" used herein specify the presence of stated features or elements, but do not preclude the presence or addition of one or more other features or elements. Additionally, spatially relative terms, such as above, below, etc. are represented herein based on the direction illustrated in the drawings and may be represented otherwise when the orientation of the corresponding object changes. In other words, such spatially relative terms are intended to encompass different orientations of the device in use or operation in addition to the orientation depicted in the figures, such that the device may be otherwise oriented (rotated 90 degrees or at other orientations) and the spatially relative terms used herein interpreted accordingly.

An element referred to with the definite article or a demonstrative determiner may be construed as the element or the elements even though it has a singular form. Operations of a method may be performed in an appropriate order unless explicitly described in terms of order or described to the contrary, and are not limited to the stated order thereof.

In the disclosure, terms such as "unit" or "module" used to denote a functional unit that has at least one function or operation may be implemented with (and/or by) processing circuitry, such as hardware, software, or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

Furthermore, line connections or connection members between elements depicted in the drawings represent functional connections and/or physical or circuit connections by way of example, and in actual applications, they may be replaced or embodied with various additional functional connections, physical connections, or circuit connections.

Examples or terms are just used herein to describe technical ideas and should not be considered for purposes of limitation unless defined by the claims.

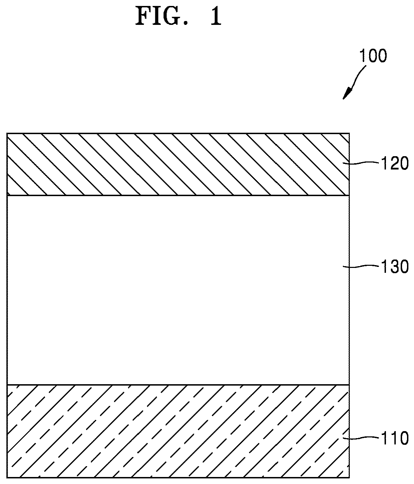

FIG. 1 is a cross-sectional view schematically illustrating a capacitor 100 according to at least one example embodiment.

Referring to FIG. 1, the capacitor 100 may include a first electrode 110, a second electrode 120 opposing the first electrode 110, and a dielectric layer 130 provided between the first electrode 110 and the second electrode 120. Here, the dielectric layer 130 may include a dielectric material having a rutile crystal phase that is stable at comparatively high temperatures and high comparatively pressures.

The first electrode 110, which may also be referred to as a lower electrode, may be disposed on a substrate (not shown). The substrate may be a portion of a structure that physically supports the capacitor 100 and/or a portion of a device connected to the capacitor 100. The substrate may include a semiconductor material pattern, an insulating material pattern, a conductive material pattern, and/or the like. For example, the substrate may include a semiconductor material such as silicon (Si), germanium (Ge), silicon germanium (SiGe), silicon carbide (SiC), gallium arsenide (GaAs), indium arsenide (InAs), or indium phosphide (InP), and/or may include an insulating material such as silicon oxide, silicon nitride, or silicon oxynitride.

The first electrode 110 may be electrically conductive and may include a metal nitride. For example, the first electrode 110 may include a metal nitride containing a Group 5B element and nitrogen. The metal nitride containing a Group 5B element may also be referred to as a Group 5B metal nitride. In these cases, the first electrode 110 may include a nitride expressed as MN (where M refers to a Group 5B element, and N refers to nitrogen). The Group 5B element may include, for example, vanadium (V), niobium (Nb), tantalum (Ta), dubnium (Db), and/or the like. The first electrode 110 may include a metal nitride in which a Group 4B element is added to a Group 5B element. In this case, the first electrode 110 may include a nitride expressed as MₓM'₁₋ₓN (where 0 < x < 1, M refers to a Group 5B element, M' refers to a Group 4B element, and N refers to nitrogen). The Group 4B element may include, for example, titanium (Ti), zirconium (Zr), hafnium (Hf), rutherfordium (Rf), or the like.

The first electrode 110 may be formed by depositing a nitride on the substrate, for example, through an atomic layer deposition (ALD) process. Because the first electrode 110 includes a nitride of a Group 5B element, the dielectric layer 130 having a rutile crystal phase may be formed on the first electrode 110 via an oxide interface region therebetween.

The second electrode 120, which is an upper electrode, may oppose the first electrode 110 at a distance from the first electrode 110. The second electrode 120 may include various conductive materials. The second electrode 120 may include, for example, a metal, a metal nitride, a metal oxide, and/or a combination thereof. For example, the second electrode 120 may include at least one conductive metal (e.g., selected from titanium (Ti), nickel (Ni), aluminum (Al), tantalum (Ta), tungsten (W), platinum (Pt), palladium (Pd), gold (Au), iridium (Ir), rhodium (Rh), molybdenum (Mo), vanadium (V), niobium (Nb), ruthenium (Ru), cobalt (Co), and/or the like), a conductive metal oxide (including at least one of the conductive metals) and/or a conductive metal nitride (including at least one of the conductive metals). For example, the conductive metal oxide may include platinum oxide (PtO), iridium oxide (IrO₂), ruthenium oxide (RuO₂), strontium ruthenium oxide (SrRuO₃), barium strontium ruthenium oxide ((Ba,Sr)RuO₃), calcium ruthenium oxide (CaRuO₃), lanthanum strontium cobalt oxide ((La,Sr)CoO₃), or the like. For example, the conductive metal nitride may include titanium nitride (TiN), tantalum nitride (TaN), niobium nitride (NbN), molybdenum nitride (MoN), cobalt nitride (CoN), tungsten nitride (WN), and/or the like.

The second electrode 120 may include a metal nitride expressed as HH'N. Here, H refers to a metal element, H' refers to an element different from H, and N refers to nitrogen. For example, H may include at least one element selected from Be, B, Na, Mg, Al, Si, K, Ca, Sc, Ti, V, Cr, Mn, Fe, Co, Ni, Cu, Zn, Ga, Ge, Rb, Sr, Y, Zr, Nb, Mo, Tc, Ru, Rh, Pd, Ag, Cd, In, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Tl, Pb, Bi, Po, Fr, Ra, Ac, Th, Pa, and/or U. For example, H' may include at least one element selected from H, Li, As, Se, N, O, P, S, Be, B, Na, Mg, Al, Si, K, Ca, Sc, Ti, V, Cr, Mn, Fe, Co, Ni, Cu, Zn, Ga, Ge, Rb, Sr, Y, Zr, Nb, Mo, Tc, Ru, Rh, Pd, Ag, Cd, In, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Tl, Pb, Bi, Po, Fr, Ra, Ac, Th, Pa, and/or U.

The dielectric layer 130 is provided between the first electrode 110 and the second electrode 120. The dielectric layer 130 may include a dielectric material having a comparatively high permittivity. For example, the dielectric layer 130 may have a dielectric constant of approximately 100 or more, but is not limited thereto. The dielectric layer 130 may include TiO₂ having a rutile crystal phase that is a crystal phase stable at comparatively high temperatures and comparatively high pressures. Here, the dielectric layer 130 may include a rutile crystal phase as a dominant phase. The expression "the dielectric layer 130 includes a rutile crystal phase as a dominant phase" indicates that when the dielectric layer 130 includes crystal phases (for example, an anatase crystal phase, a brookite crystal phase, or the like) and/or an amorphous phase in addition to a rutile crystal phase, the dielectric layer 130 includes the rutile crystal phase in the largest amount. Because the dielectric layer 130 includes a rutile crystal phase as a dominant phase, the dielectric layer 130 may exhibit high permittivity.

The dielectric layer 130 having a rutile crystal phase may be formed, for example, by depositing TiO₂ on the first electrode 110 through an ALD process. In at least some example embodiments, the dielectric layer 130 having a rutile crystal phase may be in direct contact with the first electrode 110. For example, the dielectric layer 130 may have a thickness of approximately 100 Å or less. For instance, the dielectric layer 130 may have a thickness of approximately 50 Å to approximately 100 Å, but is not limited thereto.

An oxide interface region may be further provided between the first electrode 110 and the dielectric layer 130. As described below, the oxide interface region may be formed when the dielectric layer 130 having a rutile crystal phase is deposited on an upper surface of the first electrode 110. The oxide interface region may be provided on at least a portion of the upper surface of the first electrode 110 that faces the dielectric layer 130.

The oxide interface region may include a metal oxide. For example, the oxide interface region may include a metal oxide containing a Group 5B element. In these cases, the oxide interface region may include an oxide expressed as MₙO₂ₙ₋₁ or MO₂ₙ₋₁ (where n refers to a natural number, M refers to a Group 5B element, and O refers to oxygen). For example, the Group 5B element may include vanadium (V), niobium (Nb), tantalum (Ta), dubnium (Db), and/or the like.

As described below, the oxide interface region including an oxide of a Group 5B element may facilitate the induction of the rutile crystal phase of the dielectric layer 130 during an ALD process for forming the dielectric layer 130. For example, the oxide interface region may be thin, with a thickness of approximately 12 Å or less. For example, the oxide interface region may have a thickness of approximately 5 Å to approximately 12 Å, but is not limited thereto.

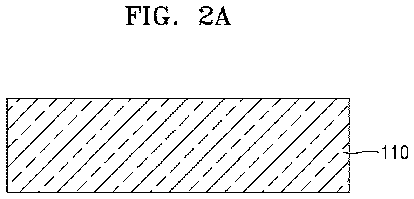

FIGS. 2A to 2C are views illustrating a method of manufacturing the capacitor 100 according to at least one example embodiment.

Referring to FIG. 2A, a first electrode 110 is formed on a substrate (not shown). As noted above, the substrate may include a semiconductor material pattern, an insulating material pattern, a conductive material pattern, and/or the like. For example, the substrate may include a semiconductor material such as silicon (Si), germanium (Ge), silicon germanium (SiGe), silicon carbide (SiC), gallium arsenide (GaAs), indium arsenide (InAs), or indium phosphide (InP), and/or may include an insulating material such as silicon oxide, silicon nitride, or silicon oxynitride.

The forming of the first electrode 110 may include, for example, an atomic layer deposition (ALD) process. For example, the first electrode 110 may be formed by depositing a metal nitride including a Group 5B element on the substrate through an ALD process. In these cases, the first electrode 110 may include a nitride expressed as MN (where M refers to a Group 5B element and N refers to nitrogen). The first electrode 110 may also be formed by depositing, on the substrate, a metal nitride in which a Group 4B element is added to a Group 5B element. In this case, the first electrode 110 may include a nitride expressed as MₓM'₁₋ₓN (0 < x < 1, M refers to a Group 5B element, M' refers to a Group 4B element, and N refers to nitrogen).

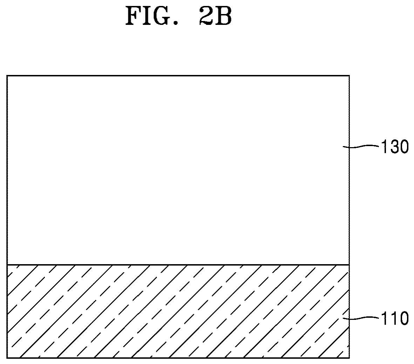

Referring to FIG. 2B, a dielectric layer 130 is formed on the first electrode 110 through an ALD process. During the ALD process, the dielectric layer 130 may be formed on the first electrode 110 including a nitride of a Group 5B element such that the dielectric layer 130 may have a rutile crystal phase.

During the formation of the dielectric layer 130, an oxide interface region may be formed between the first electrode 110 and the dielectric layer 130. For example, by exposing a surface of the first electrode 110 to the oxygen included in air, an oxide film may be naturally formed on the surface of the first electrode 110.

Thereafter, an ALD process is performed to form the dielectric layer 130 (for example, a TiO₂ layer) on the first electrode 110. First, when the dielectric layer 130 (for example, a TiO₂ layer) is initially formed on the oxide film (for example, an M₂O₅ film, where M refers to a Group 5B element and O refers to oxygen) that is naturally formed on the surface of the first electrode 110, oxygen may escape from the oxide film, and thus, an oxide interface region having a reductive phase such as M₂O₃ may be formed on at least a portion of the surface of the first electrode 110. Here, the oxide interface region may include a metal oxide containing a Group 5B element. In this case, the oxide interface region may include an oxide expressed as MₙO₂ₙ₋₁ or MO₂ₙ₋₁ (n refers to a natural number, M refers to a Group 5B element, and O refers to oxygen). The oxide interface region may have a thickness of, for example, approximately 12 Å or less. For instance, the oxide interface region may have a thickness of approximately 5 Å to 12 Å, but is not limited thereto.

Next, as the ALD process for forming the dielectric layer 130 (for example, a TiO₂ layer) continues, the dielectric layer 130 (for example, a TiO₂ layer) having a rutile crystal phase may grow from an upper surface of the first electrode 110. The dielectric layer 130 (for example, a TiO₂ layer) may have a thickness of approximately 100 Å or less. For example, the dielectric layer 130 may have a thickness of approximately 50 Å to 100 Å, but is not limited thereto. In addition, after the ALD process is completed, an additional heat treatment may be performed to make the rutile crystal phase of the dielectric layer 130 more robust.

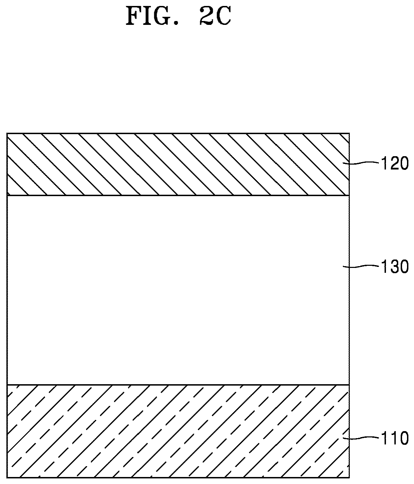

Referring to FIG. 2C, a second electrode 120 is deposited on the dielectric layer 130. As noted above, the second electrode 120 may include various conductive materials. For example, the second electrode 120 may include a metal, a metal nitride, a metal oxide, or a combination thereof. For example, the second electrode 120 may include at least one conductive metal (e.g., selected from titanium (Ti), nickel (Ni), aluminum (Al), tantalum (Ta), tungsten (W), platinum (Pt), palladium (Pd), gold (Au), iridium (Ir), rhodium (Rh), molybdenum (Mo), vanadium (V), niobium (Nb), ruthenium (Ru), cobalt (Co), and/or the like), may include a conductive metal oxide (e.g., including at least one metal) and/or a conductive metal nitride (e.g., including at least one metal). For example, the conductive metal oxide may include platinum oxide (PtO), iridium oxide (IrO₂), ruthenium oxide (RuO₂), strontium ruthenium oxide (SrRuO₃), barium strontium ruthenium oxide ((Ba,Sr)RuO₃), calcium ruthenium oxide (CaRuO₃), lanthanum strontium cobalt oxide ((La,Sr)CoO₃), or the like. For example, the conductive metal nitride may include titanium nitride (TiN), tantalum nitride (TaN), niobium nitride (NbN), molybdenum nitride (MoN), cobalt nitride (CoN), tungsten nitride (WN), or the like. The second electrode 120 may include a metal nitride expressed as AA'N. Here, A refers to a metal element, A' refers to an element different from A, and N refers to nitrogen.

As described above, in the ALD process for forming the dielectric layer 130 (for example, a TiO₂ layer), the dielectric layer 130 (for example, a TiO₂ layer) including a rutile crystal phase may be formed on the upper surface of the first electrode 110 that includes a metal nitride of a Group 5B element or a metal nitride of a Group 5B element and a Group 4B element (for example, a nitride expressed as MN or MₓM'₁₋ₓN, where 0 < x < 1, M refers to a Group 5B element, M' refers to a Group 4B element, and N refers to nitrogen).

When the ALD process is initially performed for forming the dielectric layer 130 (for example, a TiO₂ layer), the oxide interface region including a metal oxide of a Group 5B element (for example, an oxide expressed as MₙO₂ₙ₋₁ or MO₂ₙ₋₁, where n refers to a natural number, M refers to a Group 5B element, and O refers to oxygen) may be formed on the upper surface of the first electrode 110, and then, when the ALD process proceeds, the dielectric layer 130 (for example, a TiO₂ layer) including a rutile crystal phase may grow on the oxide interface region. For example, without being limited to a specific theory, the rutile crystal phase dielectric layer 130 may be promoted based on the lattice interactions between the dielectric layer 130 and the oxide interface region.

When a TiO₂ dielectric layer is provided between general metal electrodes to form a capacitor having a metal-insulator-metal (MIM) structure, the TiO₂ dielectric layer fails to have a rutile crystal phase that is stable at comparatively high temperatures and comparatively high pressures, but instead has an anatase crystal phase that exhibits low permittivity. In the capacitor 100 of the at least one example embodiment, however, the first electrode 110 includes a nitride of a Group 5B element or a nitride of a Group 5B element and a Group 4B element (for example, a nitride expressed as MN or MₓM'₁₋ₓN, where 0 < x < 1, M refers to a Group 5B element, M' refers to a Group 4B element, and N refers to nitrogen), and TiO₂ is directly grown on the first electrode 110 to form the dielectric layer 130 having a rutile crystal phase with high permittivity. As described above, the capacitor 100 of the embodiment includes a dielectric material having a rutile crystal phase with high permittivity (for example, rutile phase TiO₂). Thus, the capacitance of the capacitor 100 may be improved, and the charge storage capability of a semiconductor device (for example, dynamic random-access memory (DRAM)) including the capacitor 100 may be enhanced.

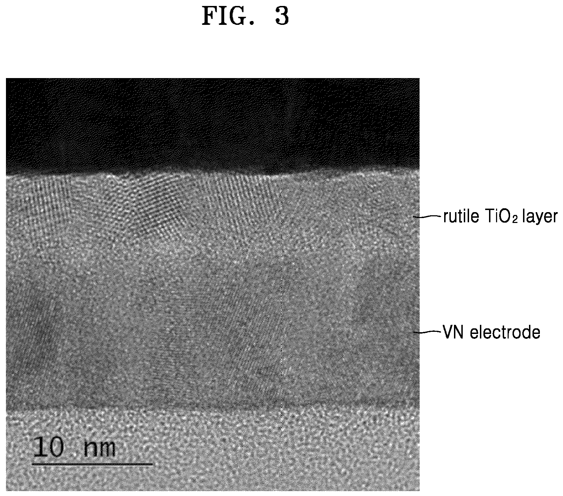

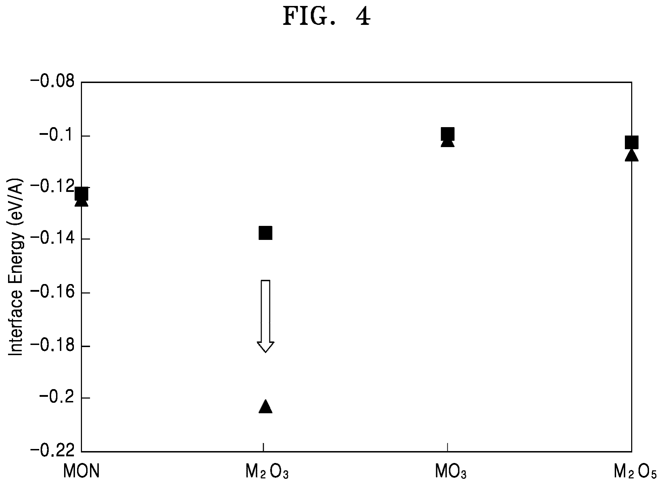

FIG. 3 shows a transmission electron microscope (TEM) image of a dielectric layer (rutile TiO₂ layer) having a rutile crystal phase, which was formed by depositing TiO₂ on a first electrode (VN electrode) through an ALD process, according to at least one example embodiment. Although not visibly shown in FIG. 3, a V₂O₃ oxide interface region having a very small thickness may be formed between the VN electrode and the rutile TiO₂ layer. FIG. 4 is a view illustrating simulation results showing variations in interface energy according to heat treatment performed on an oxynitride and oxides containing a Group 5B element (M). In FIG. 4, MON refers to an oxynitride of a Group 5B element, and M₂O₃, MO₂, and M₂O₅ refer to oxides of a Group 5B element. In FIG. 4, ■ indicates interface energy before the heat treatment, and ▲ indicates interface energy after the heat treatment. For example, the heat treatment may be performed during an ALD process for forming a dielectric layer (TiO₂ layer).

Referring to FIG. 4, it may be seen that among the oxides containing a Group 5B element (M), an oxide satisfying MₙO₂ₙ₋₁ or MO₂ₙ₋₁ (where n refers to a natural number, M refers to a Group 5B element, and O refers to oxygen), that is, M₂O₃, shows the greatest improvement in stability owing to the heat treatment.

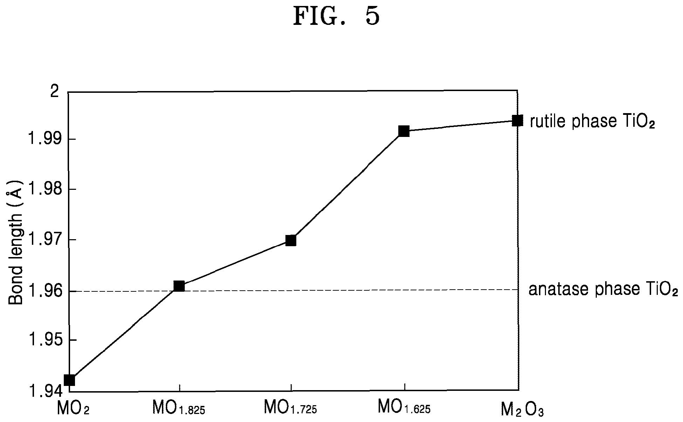

FIG. 5 is a graph illustrating crystal phases observed when TiO₂ dielectric layers were respectively grown on layers of oxides of a Group 5B element (M) through an ALD process.

Referring to FIG. 5, when TiO₂ is grown on an MO_{1.875} oxide layer among the oxides containing a Group 5B element (M), a TiO₂ layer having an anatase crystal phase may be formed. When TiO₂ is grown on an oxide layer satisfying MₙO₂ₙ₋₁ or MO₂ₙ₋₁ (where n refers to a natural number, M refers to a Group 5B element, and O refers to oxygen) among the oxides containing a Group 5B element (M), that is, when TiO₂ is grown on an M₂O₃ oxide layer, a TiO₂ layer having a rutile crystal phase may be formed.

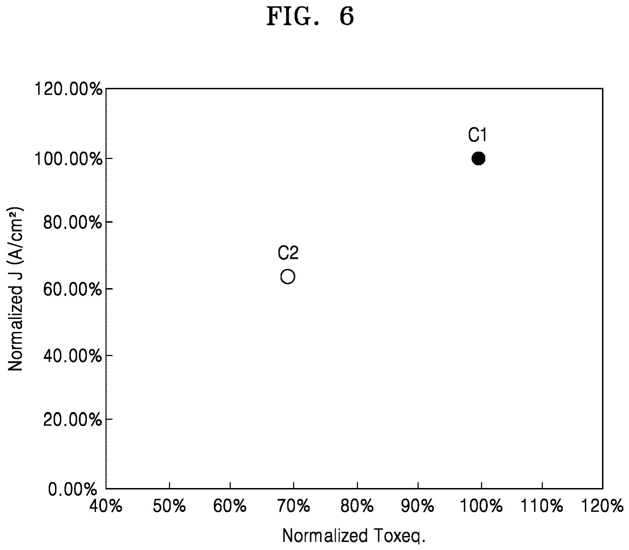

FIG. 6 is a graph illustrating results of measuring the leakage current density (J) and the equivalent oxide thickness (Toxeq.) of a capacitor of a comparative example and a capacitor of at least one example embodiment. The leakage current density was measured under an applied voltage of 1V.

In FIG. 6, "C1" indicates the capacitor of the comparative example, and "C2" indicates the capacitor of the embodiment. A capacitor including a TiO₂ dielectric layer having an anatase crystal phase between metal electrodes was used as the capacitor of the comparative example, and the capacitor 100 shown in FIG. 1 and including a TiO₂ dielectric layer having a rutile crystal phase was used as the capacitor of the embodiment.

Referring to FIG. 6, it may be seen that owing to the rutile crystal phase having high permittivity, the capacitor of the embodiment exhibits approximately a 37.8% improvement in equivalent oxide thickness and approximately a 31% reduction in leakage current density compared with the capacitor of the comparative example.

As described above, the capacitor 100 of the at least one example embodiment includes the dielectric layer 130 (a TiO₂ dielectric layer) having a high-permittivity rutile crystal phase, and thus, the capacitance of the capacitor 100 may be improved. In addition, the charge storage capability of a semiconductor device (for example, a DRAM device or the like) including the capacitor 100 may be improved.

The capacitor 100 may be employed in various semiconductor devices. For example, the capacitor 100 may form a DRAM device together with a transistor. However, embodiments are not limited thereto. For example, the capacitor 100 may form various semiconductor devices together with other semiconductor units. In addition, the capacitor 100 may form, together with other circuit elements, a portion of an electronic circuit that constitutes an electronic device.

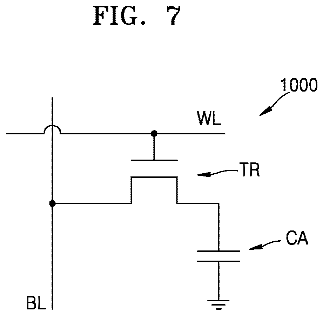

FIG. 7 is a circuit diagram schematically illustrating a circuit configuration and an operation of a semiconductor device 1000 employing the capacitor 100, according to at least one example embodiment.

Referring to FIG. 7, the circuit diagram of the semiconductor device 1000 shows a memory cell of a DRAM device, which includes a transistor TR, a capacitor CA, a word line WL, and a bit line BL. The capacitor CA may be the capacitor 100 described above according to the embodiments.

Data is written to the DRAM device as follows: a gate voltage (high) is applied to a gate electrode of the transistor TR through the word line WL to turn on the transistor TR, and then, either VDD (hereinafter, referred to as "high voltage") or 0 (hereinafter, referred to as "low voltage"), which is a data voltage value to be input, is applied to the bit line BL. When high voltage is applied to both the word line WL and the bit line BL, the capacitor CA is charged, and data "1" is written. When high voltage is applied to the word line WL and low voltage is applied to the bit line BL, the capacitor CA is discharged, and data "0" is written.

When reading data, high voltage is applied to the word line WL to turn on the transistor TR of the DRAM device, and a voltage of VDD/2 is applied to the bit line BL. When DRAM data is "1," that is, when the voltage of the capacitor CA is VDD, charges in the capacitor CA slowly move to the bit line BL, causing the voltage of the bit line BL to rise slightly above VDD/2. Conversely, when the data of the capacitor CA is "0," charges move from the bit line BL into the capacitor CA, causing the voltage of the bit line BL to drop slightly below VDD/2. This potential difference of the bit line BL may be detected and amplified by a sense amplifier to determine whether data is "0" or "1."

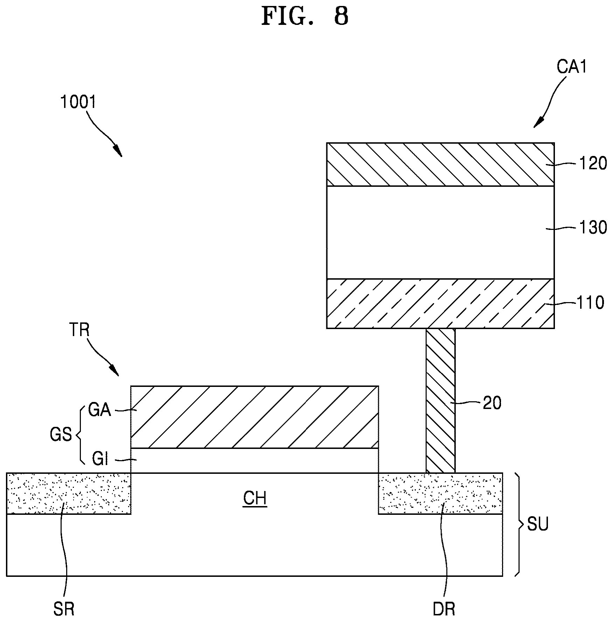

FIG. 8 is a view schematically illustrating a semiconductor device 1001 according to at least one example embodiment.

Referring to FIG. 8, the semiconductor device 1001 may include a structure in which a capacitor CA1 and a transistor TR are electrically connected to each other through a contact 20. The capacitor CA1 may include a first electrode 110, a second electrode 120 opposing the first electrode 110, and a dielectric layer 130 provided between the first electrode 110 and the second electrode 120. The capacitor CA1 may be the capacitor 100 described with reference to FIG. 1, and thus, a description of the capacitor CA1 may not be presented here.

The transistor TR may be a field-effect transistor. The transistor TR includes a semiconductor substrate SU and a gate stack GS. The semiconductor substrate SU includes a source region SR, a drain region DR, and a channel region CH. The gate stack GS is disposed on the semiconductor substrate SU to face the channel region CH. The gate stack GS includes a gate insulating layer GI and a gate electrode GA.

The channel region CH is provided between the source region SR and the drain region DR and is electrically connected to the source region SR and the drain region DR. The source region SR may be electrically connected to or may be in contact with an end portion of the channel region CH, and the drain region DR may be electrically connected to or may be in contact with another end portion of the channel region CH. The channel region CH may be a substrate region defined within the semiconductor substrate SU between the source region SR and the drain region DR.

The semiconductor substrate SU may include a semiconductor material. For example, the semiconductor substrate SU may include a semiconductor material such as silicon (Si), germanium (Ge), silicon germanium (SiGe), silicon carbide (SiC), gallium arsenide (GaAs), indium arsenide (InAs), or indium phosphide (InP). In addition, the semiconductor substrate SU may include a silicon-on-insulator (SOI) substrate.

The source region SR, the drain region DR, and the channel region CH may be formed by independently implanting dopants into different regions of the semiconductor substrate SU. In this case, the source region SR, the channel region CH, and the drain region DR may include a material of the semiconductor substrate SU as a base material. The source region SR and the drain region DR may include a conductive material. In this case, the source region SR and the drain region DR may include, for example, a metal, a metal compound, or a conductive polymer.

Unlike the illustration in FIG. 8, the channel region CH may be implemented as a separate material layer (thin film). In this case, for example, the channel region CH may include at least one selected from Si, Ge, SiGe, a Group III-V semiconductor, an oxide semiconductor, a nitride semiconductor, an oxynitride semiconductor, a two-dimensional (2D) material, quantum dots (QDs), and an organic semiconductor. For example, the oxide semiconductor may include InGaZnO or the like, the 2D material may include a transition metal dichalcogenide (TMD) or graphene, and the QDs may include colloidal QDs or nanocrystal structures.

The gate electrode GA may be disposed above the semiconductor substrate SU and may be opposite the channel region CH at a distance from the semiconductor substrate SU. The gate electrode GA may include at least one selected from a metal, a metal nitride, a metal carbide, and polysilicon. For example, the metal may include at least one selected from aluminum (Al), tungsten (W), molybdenum (Mo), titanium (Ti), tantalum (Ta), and/or the like. The metal nitride may include at least one selected from titanium nitride (TiN), tantalum nitride (TaN), and/or the like. The metal carbide may include at least one selected from metal carbides doped with (or containing) aluminum or silicon. For example, the metal carbide may include TiAlC, TaAlC, TiSiC, TaSiC, and/or the like.

The gate electrode GA may have a structure in which a plurality of materials are stacked. For example, the gate electrode GA may include a stacked structure of a metal nitride layer/metal layer such as TiN/Al, or a stacked structure of a metal nitride layer/metal carbide layer/metal layer such as TiN/TiAlC/W. However, the materials mentioned above are only examples.

The gate insulating layer GI may further be disposed between the semiconductor substrate SU and the gate electrode GA. The gate insulating layer GI may include a paraelectric material or a high-k dielectric material and may have a dielectric constant of approximately 20 to approximately 70.

The gate insulating layer GI may include silicon oxide, silicon nitride, aluminum oxide, hafnium oxide, zirconium oxide, or the like, or may include a 2D insulator such as hexagonal boron nitride (h-BN). For example, the gate insulating layer GI may include silicon oxide (SiO₂), silicon nitride (SiNx), hafnium oxide (HfO₂), hafnium silicon oxide (HfSiO₄), lanthanum oxide (La₂O₃), lanthanum aluminum oxide (LaAlO₃), zirconium oxide (ZrO₂), hafnium zirconium oxide (HfZrO₂), zirconium silicon oxide (ZrSiO₄), tantalum oxide (Ta₂O₅), titanium oxide (TiO₂), strontium titanium oxide (SrTiO₃), yttrium oxide (Y₂O₃), aluminum oxide (Al₂O₃), lead scandium tantalum oxide (PbSc_{0.5}Ta_{0.5}O₃), lead zinc niobate (PbZnNbO₃), or the like. In addition, the gate insulating layer GI may include: a metal oxynitride such as aluminum oxynitride (AlON), zirconium oxynitride (ZrON), hafnium oxynitride (HfON), lanthanum oxynitride (LaON), or yttrium oxynitride (YON); a silicate such as ZrSiON, HfSiON, YSiON, or LaSiON; or an aluminate such as ZrAlON or HfAlON. The gate insulating layer GI may form the gate stack GS together with the gate electrode GA.

One of the first and second electrodes 110 and 120 of the capacitor CA1 and one of the source region SR and the drain region DR of the transistor TR may be electrically connected to each other through the contact 20. Here, the contact 20 may include a conductive material such as tungsten, copper, aluminum, or polysilicon.

The arrangement of the capacitor CA1 and the transistor TR may be variously modified. For example, the capacitor CA1 may be disposed above the semiconductor substrate SU or may be embedded in the semiconductor substrate SU.

Although FIG. 8 illustrates that the semiconductor device 1001 includes one capacitor CA1 and one transistor TR, this is only an example. The semiconductor device 1001 may include a plurality of capacitors and a plurality of transistors.

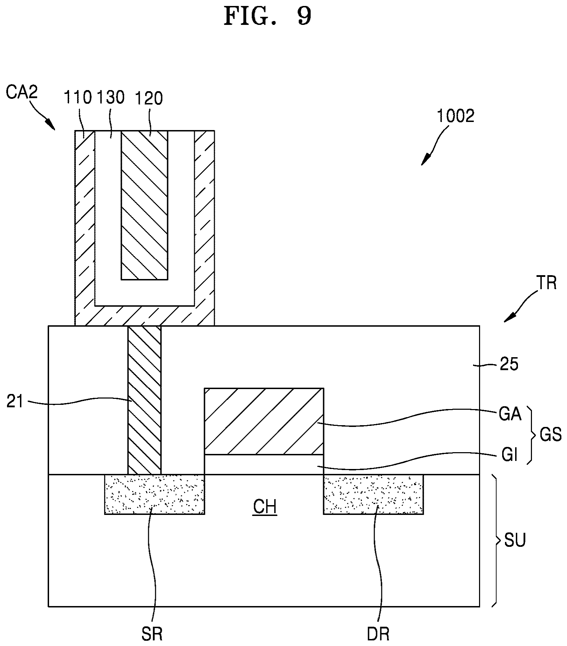

FIG. 9 illustrates a semiconductor device 1002 according to at least one example embodiment.

Referring to FIG. 9, the semiconductor device 1002 may include a structure in which a capacitor CA2 and a transistor TR are electrically connected to each other through a contact 21. The transistor TR includes a semiconductor substrate SU and a gate stack GS. The semiconductor substrate SU includes a source region SR, a drain region DR, and a channel region CH. The gate stack GS is disposed on the semiconductor substrate SU to face the channel region CH. The gate stack GS includes a gate insulating layer GI and a gate electrode GA.

An interlayer insulating layer 25 may be provided on the semiconductor substrate SU to cover the gate stack GS. The interlayer insulating layer 25 may include an insulating material. For example, the interlayer insulating layer 25 may include silicon oxide (for example, SiO₂), aluminum oxide (for example, Al₂O₃), or a high-k dielectric material (for example, HfO₂). The contact 21 penetrates the interlayer insulating layer 25 and electrically connects the transistor TR and the capacitor CA2 to each other.

The capacitor CA2 may include a first electrode 110, a second electrode 120 opposing the first electrode 110, and a dielectric layer 130 provided between the first electrode 110 and the second electrode 120. The first electrode 110 and the second electrode 120 are shaped to increase the contact area with the dielectric layer 130. Otherwise, the capacitor CA2 may be the same as (and/or substantially similar to) the capacitor 100 described with reference to FIG. 1, and thus, a description of the capacitor CA2 may not be presented here.

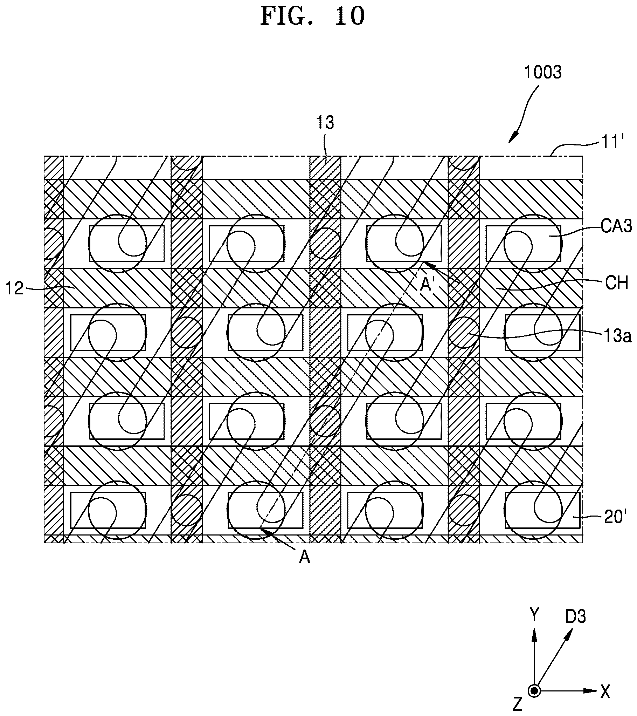

FIG. 10 is a plan view illustrating a semiconductor device 1003 according to at least one example embodiment.

Referring to FIG. 10, the semiconductor device 1003 has a structure in which a plurality of capacitors CA3 and a plurality of field-effect transistors are repetitively arranged. Referring to FIG. 10, the semiconductor device 1003 may include: a semiconductor substrate 11' including sources, drains, and channels; the field-effect transistors including gate stacks 12; contact structures 20' arranged on the semiconductor substrate 11' without overlapping the gate stacks 12; and the capacitors CA3 arranged on the contact structures 20'. The semiconductor device 1003 may further include bit line structures 13 electrically connecting the field-effect transistors to each other.

Although FIG. 10 illustrates an example in which the contact structures 20' and the capacitors CA3 are repetitively arranged in X and Y directions, embodiments are not limited thereto. For example, the contact structures 20' may be arranged in the X and Y directions, and the capacitors CA3 may be arranged in a hexagonal shape such as a honeycomb shape.

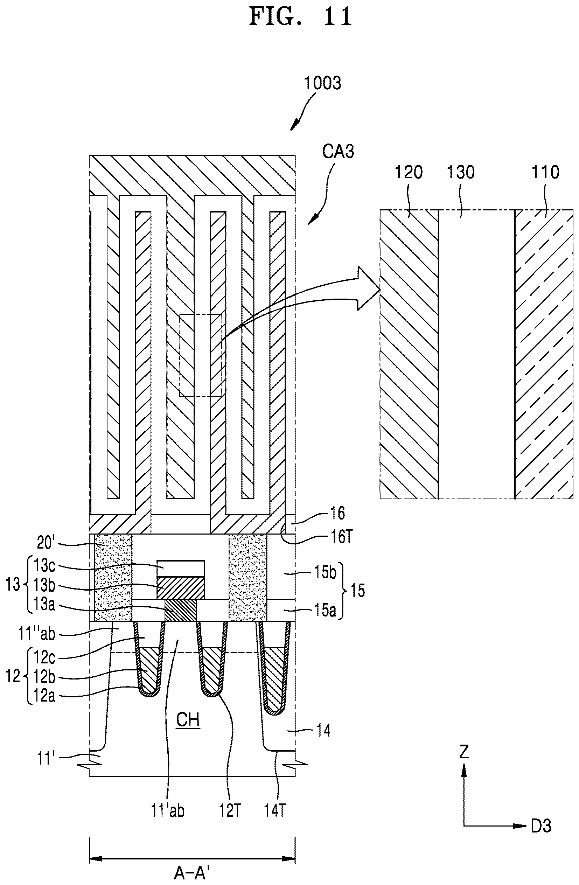

FIG. 11 is a cross-sectional view taken along line A-A' of FIG. 10.

Referring to FIG. 11, the semiconductor substrate 11' may have a shallow trench isolation (STI) structure including a device isolation layer 14. The device isolation layer 14 may have a single-layer structure formed by one type of insulating layer or a multilayer structure formed by a combination of two or more types of insulating layers. The device isolation layer 14 may include a device isolation trench 14T in the semiconductor substrate 11', and the device isolation trench 14T may be filled with an insulating material. The insulating material may include at least one selected from fluoride silicate glass (FSG), undoped silicate glass (USG), boro-phospho-silicate glass (BPSG), phospho-silicate glass (PSG), flowable oxide (FOX), plasma enhanced tetra-ethyl-ortho-silicate (PE-TEOS), and Tonen SilaZene (TOSZ). However, the example embodiments are not limited thereto.

The semiconductor substrate 11' may further include a channel region CH defined by the device isolation layer 14, and gate line trenches 12T arranged parallel to an upper surface of the semiconductor substrate 11' and extending in the X direction. The channel region CH may have a relatively long island shape with a major axis and a minor axis. As illustrated in FIG. 10, the major axis of the channel region CH may be aligned with a direction D3 parallel to the upper surface of the semiconductor substrate 11'.

The gate line trenches 12T may intersect the channel region CH at a predetermined depth from the upper surface of the semiconductor substrate 11' or may be arranged within the channel region CH. A gate line trench 12T may be disposed inside the device isolation trench 14T. For example, a bottom surface of the gate line trench 12T disposed inside the device isolation trench 14T may be lower than bottom surfaces of the gate line trenches 12T disposed inside the channel region CH. A first source/drain 11'ab and a second source/drain 11"ab may be arranged in an upper portion of the channel region CH at both sides of each of the gate line trenches 12T.

A gate stack 12 may be disposed in each of the gate line trenches 12T. For example, a gate insulating layer 12a, a gate electrode 12b, and a gate capping layer 12c may be sequentially disposed in each of the gate line trenches 12T. The gate insulating layer 12a and the gate electrode 12b may be understood by referencing the description given above. The gate capping layer 12c may include at least one selected from silicon oxide, silicon oxynitride, and silicon nitride. The gate capping layer 12c may be disposed on the gate electrode 12b to fill a remaining portion of the gate line trench 12T.

A bit line structure 13 may be disposed on the first source/drain 11'ab. The bit line structure 13 may be provided parallel to the upper surface of the semiconductor substrate 11' and may extend in the Y direction. The bit line structure 13 may be electrically connected to the first source/drain 11'ab. The bit line structure 13 may include, sequentially from the semiconductor substrate 11', a bit line contact 13a, a bit line 13b, and a bit line capping layer 13c. For example, the bit line contact 13a may include polysilicon, the bit line 13b may include a metal material, and the bit line capping layer 13c may include an insulating material such as silicon nitride or silicon oxynitride.

FIG. 11 illustrates an example in which the bit line contact 13a has a bottom surface at the same level as the upper surface of the semiconductor substrate 11', but this is merely illustrative and not limiting. In at least one example embodiment, for example, a recess may be formed to a predetermined depth from the upper surface of the semiconductor substrate 11', and the bit line contact 13a may extend into the recess, such that the bottom surface of the bit line contact 13a may be lower than the upper surface of the semiconductor substrate 11'.

The bit line structure 13 may further include an intermediate layer (not shown) between the bit line contact 13a and the bit line 13b. The intermediate layer may include a metal silicide such as tungsten silicide, or a metal nitride such as tungsten nitride. Additionally, a bit line spacer (not shown) may be formed on a side wall of the bit line structure 13. The bit line spacer may have a single-layer or multilayer structure and may include an insulating material such as silicon oxide, silicon oxynitride, or silicon nitride. The bit line spacer may further include an air gap (not shown).

A contact structure 20' may be disposed on the second source/drain 11"ab. The contact structure 20' and the bit line structure 13 may be disposed on different source/drains of the semiconductor substrate 11'. The contact structure 20' may be provided by sequentially stacking a lower contact pattern (not shown), a metal silicide layer (not shown), and an upper contact pattern (not shown) on the second source/drain 11"ab. In addition, the contact structure 20' may further include a barrier layer (not shown) surrounding lateral and bottom surfaces of the upper contact pattern. For example, the lower contact pattern may include polysilicon, the upper contact pattern may include a metal material, and the barrier layer may include a conductive metal nitride.

A capacitor CA3 may be electrically connected to the contact structure 20' and disposed above the semiconductor substrate 11'. For example, the capacitor CA3 includes a first electrode 110 electrically connected to the contact structure 20', a second electrode 120 provided apart from the first electrode 110, and a dielectric layer 130 disposed between the first electrode 110 and the second electrode 120.

The first electrode 110 may have a cylindrical shape or a cup shape with a closed-bottom internal space. The second electrode 120 may have a comb shape having prongs extending into internal spaces of first electrodes 110 and regions between adjacent first electrodes 110. The dielectric layer 130 may be disposed between the first electrode 110 and the second electrode 120 in a direction parallel to surfaces of the first and second electrodes 110 and 120. Otherwise, the capacitor CA3 may be the same as and/or substantially similar to the capacitor 100 described with reference to FIG. 1, and thus, a description of the capacitor CA3 may not be presented here.

An interlayer insulating layer 15 may be further disposed between the capacitor CA3 and the semiconductor substrate 11'. The interlayer insulating layer 15 may be provided in a space between the capacitor CA3 and the semiconductor substrate 11' in which no other structures are arranged. For example, the interlayer insulating layer 15 may cover wiring and/or electrode structures, such as the bit line structure 13, the contact structure 20', and the gate stack 12, which are provided on the semiconductor substrate 11'. For example, the interlayer insulating layer 15 may surround walls of the contact structure 20'. The interlayer insulating layer 15 may include a first interlayer insulating layer 15a surrounding the bit line contact 13a, and a second interlayer insulating layer 15b covering lateral surfaces and/or upper surfaces of the bit line 13b and the bit line capping layer 13c.

The first electrode 110 of the capacitor CA3 may be disposed on the interlayer insulating layer 15, for example, on the second interlayer insulating layer 15b of the interlayer insulating layer 15. When a plurality of capacitors CA3 are arranged, bottom surfaces of first electrodes 110 may be separated from each other by an etch stop layer 16. In other words, the etch stop layer 16 may include openings 16T, and the bottom surfaces of the first electrodes 110 of the capacitors CA3 may be arranged within the openings 16T. As illustrated in FIG. 11, the first electrodes 110 may have a cylindrical shape or a cup shape with a closed-bottom internal space. The capacitor CA3 may further include a support (not shown) that prevents the tilting or collapse of the second electrode 120, and the support may be disposed on a side wall of the second electrode 120.

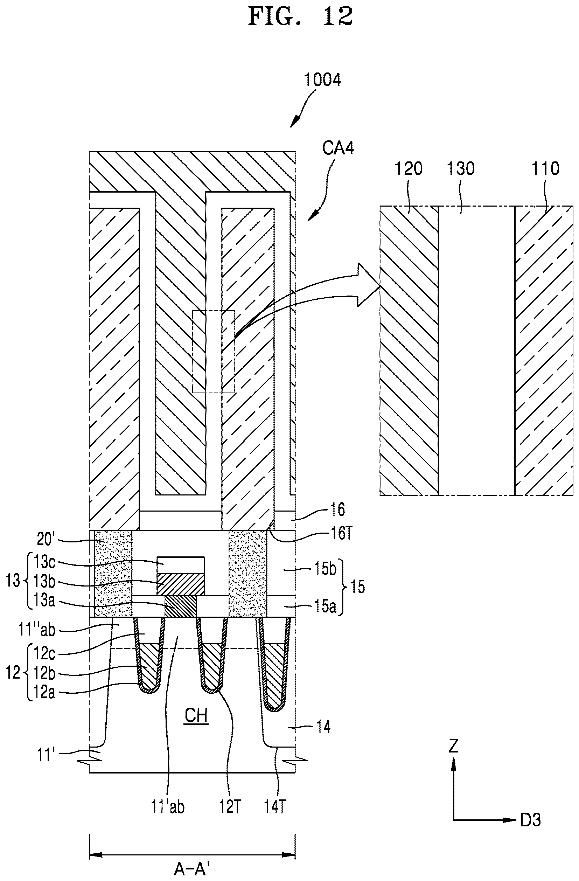

FIG. 12 is a cross-sectional view illustrating a semiconductor device 1004 according to at least one example embodiment.

The semiconductor device 1004 of the current embodiment is illustrated with a cross-sectional view corresponding to the cross-sectional view taken along line A-A' of FIG. 10, and differs from the semiconductor device 1003 shown in FIG. 11 only in the shape of a capacitor CA4. The capacitor CA4 is electrically connected to a contact structure 20' and disposed above a semiconductor substrate 11'. The capacitor CA4 includes a first electrode 110 electrically connected to the contact structure 20', a second electrode 120 provided apart from the first electrode 110, and a dielectric layer 130 disposed between the first electrode 110 and the second electrode 120.

The first electrode 110 may have a pillar shape, such as a cylindrical, rectangular, or polygonal pillar shape extending in a vertical direction (Z direction). The second electrode 120 may have a comb shape with prongs extending into regions between adjacent first electrodes 110. The dielectric layer 130 may be disposed between the first electrode 110 and the second electrode 120 in a direction parallel to surfaces of the first and second electrodes 110 and 120. Otherwise, the capacitor CA4 may be the same as and/or substantially similar to the capacitor 100 described with reference to FIG. 1, and thus, a description of the capacitor CA4 may not be prevented here.

The capacitors and semiconductor devices described above in the embodiments may be used in various application fields. For example, the semiconductor devices of the embodiments may be used as logic devices or memory devices. The semiconductor devices of the embodiments may be used for tasks such as arithmetic operations, program execution, or temporary data retention in devices such as mobile devices, computers, laptops, sensors, network devices, and neuromorphic devices. Additionally, the semiconductor devices of the embodiments may be used in electronic devices that involve large amounts of data transmission and continuous data transfer.

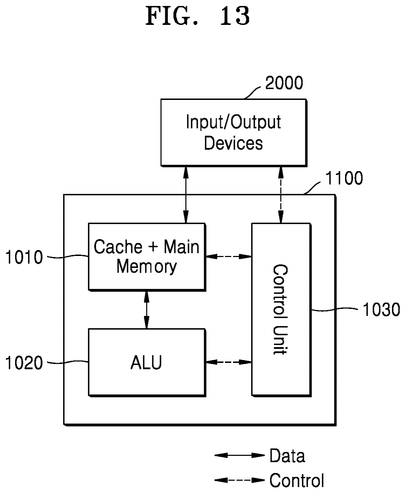

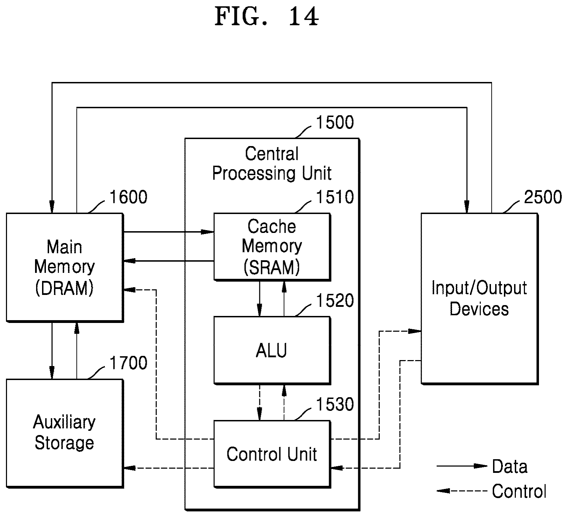

FIGS. 13 and 14 are conceptual views schematically illustrating electronic device architectures appliable to electronic devices according to embodiments.

Referring to FIG. 13, an electronic device architecture 1100 may include a memory unit 1010, an arithmetic logic unit (ALU) 1020, and a control unit 1030. The memory unit 1010, the ALU 1020, and the control unit 1030 may be electrically connected to each other. For example, the electronic device architecture 1100 may be implemented as one chip including the memory unit 1010, the ALU 1020, and the control unit 1030.

The memory unit 1010, the ALU 1020, and the control unit 1030 may be interconnected with each other on a chip through metal lines for direct communication with each other. The memory unit 1010, the ALU 1020, and the control unit 1030 may be monolithically integrated on a single substrate to form a single chip. Input/output devices 2000 may be connected to the electronic device architecture (chip) 1100. In addition, the memory unit 1010 may include a main memory and a cache memory. The electronic device architecture (chip) 1100 may be an on-chip memory processing unit. The memory unit 1010 may include the capacitors and the semiconductor devices described above. The ALU 1020 and the control unit 1030 may each include one or more of the capacitors and/or semiconductor devices described above.

Referring to FIG. 14, a cache memory 1510, an ALU 1520, and a control unit 1530 may form a central processing unit (CPU) 1500. The cache memory 1510 may include a static random-access memory (SRAM). A main memory 1600 and an auxiliary storage 1700 may be provided separately from the CPU 1500. The main memory 1600 may include a DRAM device including one or more of the capacitors and/or semiconductor devices described above. In some cases, the electronic device architectures may be implemented in the form in which unit computing devices and unit memory devices are adjacent to each other on one chip without any distinction between sub-units.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A capacitor comprising:
a first electrode, the first electrode comprising a metal nitride, the metal nitride comprising a nitride of a Group 5B element or a nitride of the Group 5B element and a Group 4B element;
a second electrode opposing the first electrode; and
a dielectric layer between the first electrode and the second electrode, the dielectric layer and comprising a rutile crystal phase.

2. The capacitor of claim 1, wherein the dielectric layer is in direct contact with the first electrode.

3. The capacitor of claim 1 or 2, wherein the dielectric layer comprises TiO₂.

4. The capacitor of any preceding claim, wherein the dielectric layer comprises the rutile crystal phase as a dominant phase.

5. The capacitor of any preceding claim, wherein the dielectric layer has a thickness of 100 Å or less.

6. The capacitor of any preceding claim, wherein the Group 5B element comprises at least one of V, Nb, Ta, or Db.

7. The capacitor of any preceding claim, wherein the Group 4B element comprises at least one of Ti, Zr, Hf, or Rf.

8. The capacitor of any preceding claim, wherein the metal nitride is represented by MN or MₓM'₁₋ₓN, where 0<x<1, M refers to the Group 5B element, M' refers to the Group 4B element, and N refers to nitrogen.

9. A semiconductor device comprising:
a capacitor according to any preceding claim.

10. A method of manufacturing a semiconductor device comprising a capacitor, the method comprising:
forming a first electrode comprising a metal nitride, the metal nitride comprising a Group 5B element;
forming a dielectric layer on the first electrode such that the dielectric layer comprises a rutile crystal phase; and
forming a second electrode on the dielectric layer.

11. The method of claim 10, wherein the first electrode further comprises a Group 4B element.

12. The method of claim 11, wherein the Group 4B element comprises at least one of Ti, Zr, Hf, or Rf.

13. The method of any of claims 10 to 12, wherein the forming of the dielectric layer comprises directly depositing TiO₂ on the first electrode through an atomic layer deposition (ALD) process.

14. The method of any of claims 10 to 13, wherein the dielectric layer comprises the rutile crystal phase as a dominant phase.

15. The method of any of claims 10 to 14, wherein the forming the dielectric layer includes forming the dielectric layer such that the dielectric layer has a thickness of 100 Å or less.
